# EUROPEAN PATENT APPLICATION

(11) **EP 4 835 933 A1**
(43) Date of publication of application: **04.11.2026**
(21) Application number: 26175461.8
(22) Date of filing: 29.04.2026
(51) Int. Cl.: H01H 9/28, H01H 9/02, G01R 31/327, H01H 1/00, H01H 1/42, H01H 21/54

(54) **HINGED FRONT SAFETY BARRIER FOR TEST SWITCHES**

(30) Priority: 29.04.2025 US 202519192663
(71) Applicant: ABB Schweiz AG, 5400 Baden (CH)
(72) Inventor: KOBYLANSKI, Alex, 28112 Monroe (US)
(74) Representative: Zimmermann & Partner Patentanwälte mbB

(57) **Abstract**

A switch safety barrier is described. The switch safety barrier includes a base configured to be positioned on a switch for multi-circuit testing and a cover connected to the base by a first hinge at a first end of the cover and a second hinge at a second end of the cover, wherein the cover is movable between a first engaged position and a second engaged position with the base. The base includes a first arm and a second arm, a bridge portion extending between and connecting the first arm and the second arm, and at least one flap pair extending from the bridge portion. The cover includes at least one barrier rib extending from the cover, each barrier rib corresponding to one of the at least one flap pair.

## Description

### TECHNICAL FIELD

The field of disclosure relates generally to safety barriers, and more particularly, to a hinged safety barrier for use with switches for multi-circuit testing.

### BACKGROUND

Currently in the industry, switches for use in multi-circuit testing of switchboard relays, meters, and instruments expose switch operators to safety risks due to ease of contact with live elements within the switches. However, existing protective measures are limited in their applications and effectiveness to reduce these safety risks. For example, dividers are a commonly used protective measure. However, dividers may offer limited protection to operators, may expose operators to additional safety risks to install these dividers, and may not be compatible with additional components, such as separate source test plugs, for use with these switches.

Based on the foregoing, a need exists for an easy to install, more reliable, and safer safety barrier for these switches.

This background section is intended to introduce the reader to various aspects of art that may be related to various aspects of the present disclosure, which are described and/or claimed below. This discussion is believed to be helpful in providing the reader with supporting information to facilitate a better understanding of the various aspects of the present disclosure. Accordingly, it should be understood that these statements are to be read in this light, and not as admissions of prior art.

### BRIEF DESCRIPTION

In one aspect, a switch safety barrier is described. The switch safety barrier comprises a base configured to be positioned on a switch for multi-circuit testing and a cover connected to the base by a first hinge at a first end of the cover and a second hinge at a second end of the cover, wherein the cover is movable between a first engaged position and a second engaged position with the base. The base comprises a first arm and a second arm, a bridge portion extending between and connecting the first arm and the second arm and at least one flap pair extending from the bridge portion. The cover comprises at least one barrier rib extending from the cover, each barrier rib corresponding to one of the at least one flap pair.

In another aspect, a switch for multicircuit testing is described. The switch comprises at least one test switch blade, a switch body configured to house the at least one test switch blade, and a safety barrier positioned on the switch body. The safety barrier comprises a base configured to be positioned on a switch for multi-circuit testing and a cover connected to the base by a first hinge at a first end of the cover and a second hinge at a second end of the cover, wherein the cover is movable between a first engaged position and a second engaged position with the base. The base comprises a first arm and a second arm, a bridge portion extending between and connecting the first arm and the second arm and at least one flap pair extending from the bridge portion. The cover comprises at least one barrier rib extending from the cover, each barrier rib corresponding to one of the at least one flap pair.

In yet another aspect, a method of assembly for a safety barrier for a switch for multi-circuit testing is described. The method comprises providing a base. The base comprises a first arm and a second arm, a bridge portion extending between and connecting the first arm and the second arm and at least one flap pair extending from the bridge portion. The method further comprises attaching at least one hinge to the base and attaching a cover to the at least one hinge to allow the cover to move between a first engaged position and a second engaged position with the base. The cover comprises at least one barrier rib extending from the cover, each barrier rib corresponding to one of the at least one flap pair.

Various refinements exist of the features noted in relation to the above-mentioned aspects. Further features may also be incorporated in the above-mentioned aspects as well. These refinements and additional features may exist individually or in any combination. For instance, various features discussed below in relation to any of the illustrated examples may be incorporated into any of the above-described aspects, alone or in any combination.

### BRIEF DESCRIPTION OF DRAWINGS

The following drawings form part of the present specification and are included to further demonstrate certain aspects of the present disclosure. The disclosure may be better understood by reference to one or more of these drawings in combination with the detailed description of specific embodiments presented herein.
Fig. 1A depicts a front view of a safety barrier for a switch for multi-circuit testing with a cover of the safety barrier disposed in a first engaged position with a base of the safety barrier;
Fig. 1B depicts a perspective view of the safety barrier of Fig. 1A with the cover of the safety barrier disposed in the first engaged position with the base of the safety barrier;
Fig. 1C depicts a side view of the safety barrier of Figs. 1A and 1B with the cover of the safety barrier disposed in the first engaged position with the base of the safety barrier;
Fig. 2A depicts a front view of a base of the safety barrier shown in Figs. 1A-1C;
Fig. 2B depicts a perspective view of the base of the safety barrier shown in Figs. 1A-1C;
Fig. 2C depicts a top view of the base of the safety barrier shown in Figs. 1A-1C;
Fig. 3A depicts a front view of a cover of the safety barrier shown in Figs. 1A-1C;
Fig. 3B depicts a perspective view of the cover of the safety barrier shown in Figs. 1A-1C;
Fig. 4 depicts a front view of a hinge of the safety barrier shown in Figs. 1A-1C;
Fig. 5A depicts a front view of a switch for multi-circuit testing with the safety barrier shown in Figs. 1A-1C with the cover of the safety barrier disposed in the first engaged position with the base of the safety barrier;
Fig. 5B depicts a perspective view of the switch for multi-circuit testing with the safety barrier shown in Figs. 1A-1C with the cover of the safety barrier disposed in the first engaged position with the base of the safety barrier;
Fig. 6A depicts a perspective view of the switch for multi-circuit testing shown in Figs. 5A and 5B with the safety barrier of Figs. 1A-1C during movement of the cover from the first engaged position to a second engaged position;
Fig. 6B depicts a side view of the switch for multi-circuit testing shown in Figs. 5A and 5B with the safety barrier of Figs. 1A-1C during the movement of the cover from the first engaged position to the second engaged position;
Fig. 7 depicts a side view of the safety barrier shown in Figs. 1A-1C during movement of the cover from the first engaged position to the second engaged position;
Fig. 8A depicts a front view of the switch for multi-circuit testing shown in Figs. 5A and 5B with the safety barrier shown in Figs. 1A-1C in the second engaged position;
Fig. 8B depicts a perspective view of the switch for multi-circuit testing shown in Figs. 5A and 5B with the safety barrier shown in Figs. 1A-1C with the cover of the safety barrier disposed in the second engaged position with the base of the safety barrier;
Fig. 9 depicts a side view of the safety barrier of Figs. 1A-1C with the cover of the safety barrier disposed in second engaged position with the base of the safety barrier; and
Fig. 10 depicts a flowchart of an exemplary method of assembly for a safety barrier for a switch for multi-circuit testing.

Corresponding reference characters indicate corresponding parts throughout the several views of the drawings. Although specific features of various examples may be shown in some drawings and not in others, this is for convenience only. Any feature of any drawing may be referenced or claimed in combination with any feature of any other drawing.

### DETAILED DESCRIPTION

The following detailed description and examples set forth preferred materials, components, and procedures used in accordance with the present disclosure. This description and these examples, however, are provided by way of illustration only, and nothing therein shall be deemed to be a limitation upon the overall scope of the present disclosure.

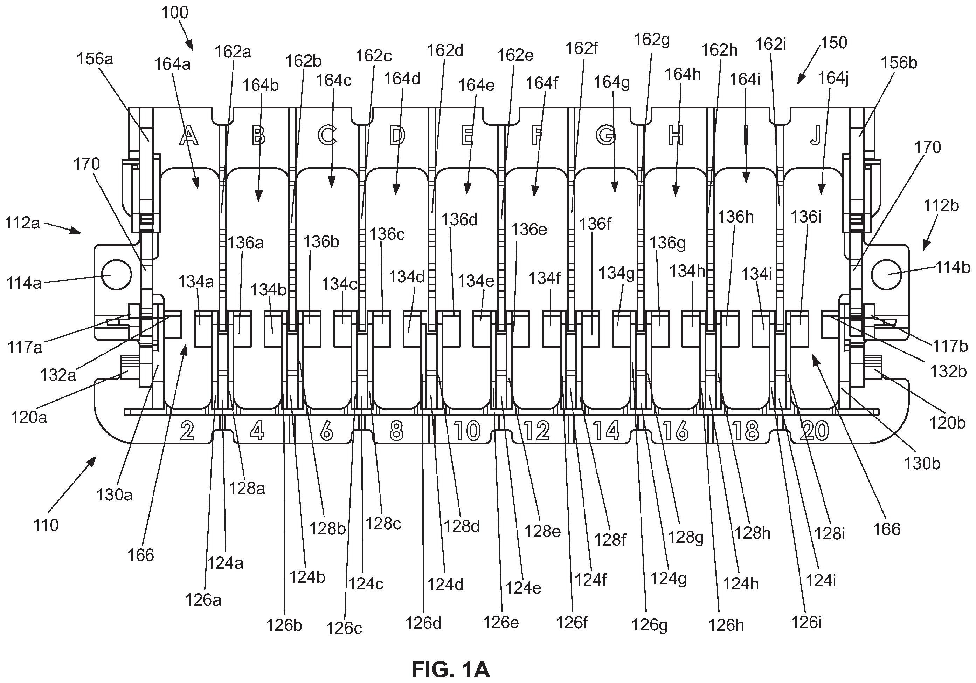

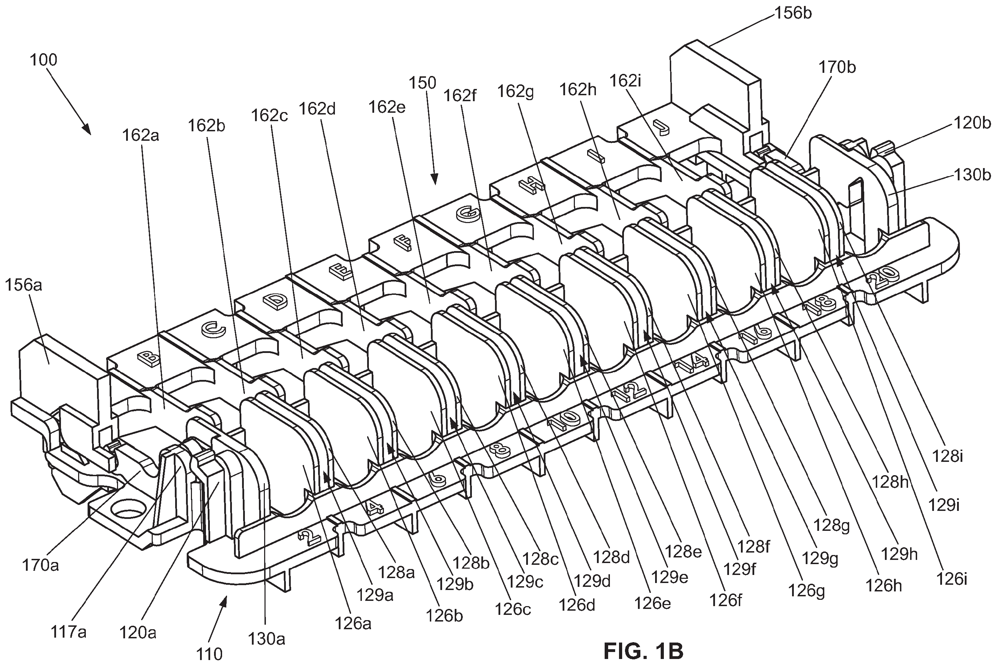

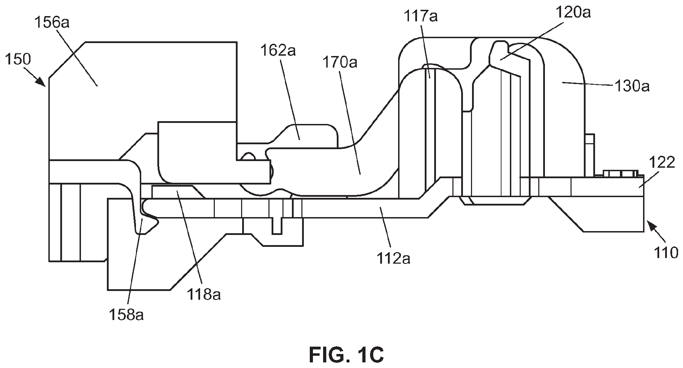

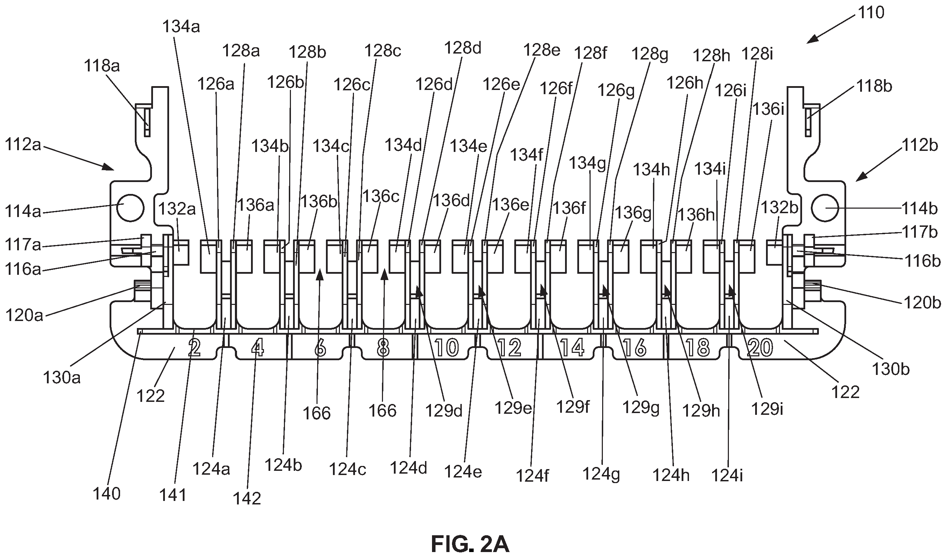

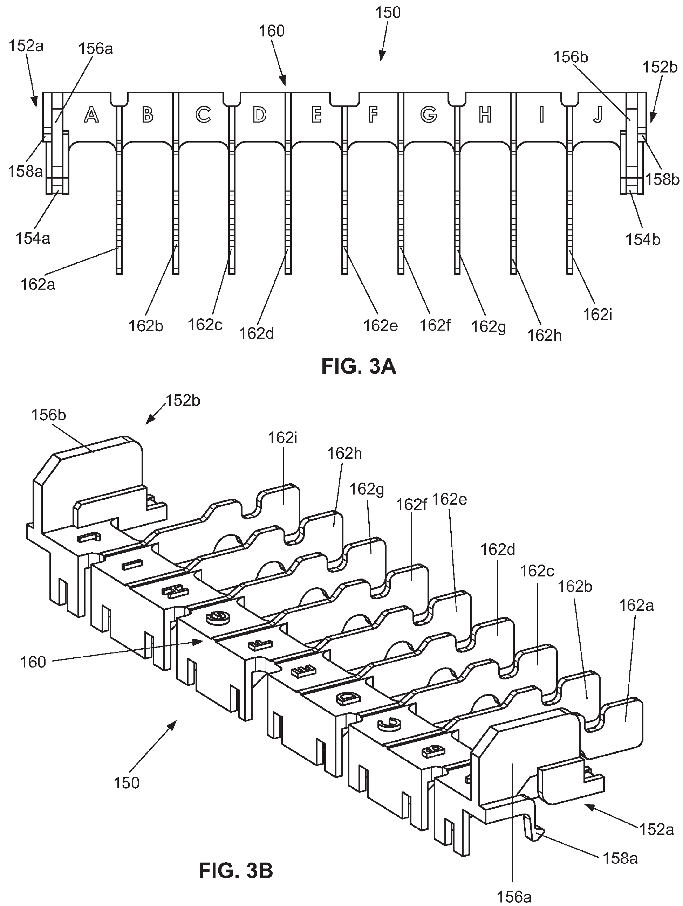

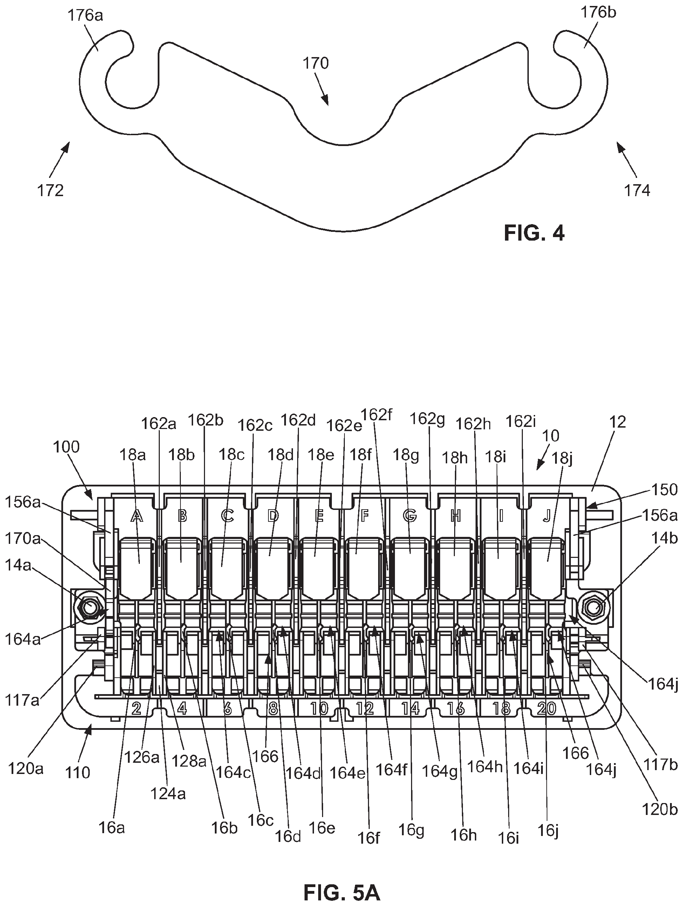

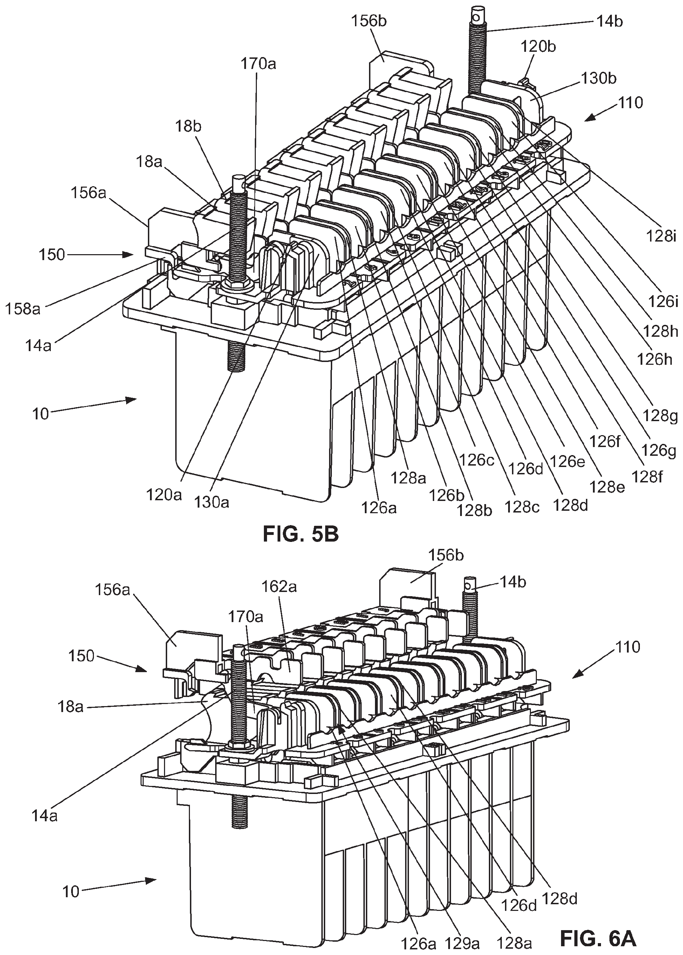

Figs. 1A, 1B, and 1C illustrate a front view, a perspective view, and a side view, respectively, of a safety barrier 100 for a switch for multi-circuit testing showing a cover 150 of the safety barrier 100 disposed in a first engaged position with a base 110 of the safety barrier 110. The safety barrier 100 includes the base 110 and the cover 150 hingably connected to the base 110. The base 110 is shown in Figs. 2A-2C. The cover 150 is shown in Figs. 3A and 3B. Each of the base 110 and the cover 150 may be made of a polycarbonate material and/or any other suitable plastic material. The safety barrier 100 may be quickly positioned on a switch for multi-circuit testing, as described in reference to Figs. 5A and 5B herein, to prevent accidental contact with and between live elements within the switch when conducting multi-circuit testing. The safety barrier 100 may additionally be compatible with components that are commonly used with switches for multi-circuit testing, such as covers, clips, or the like.

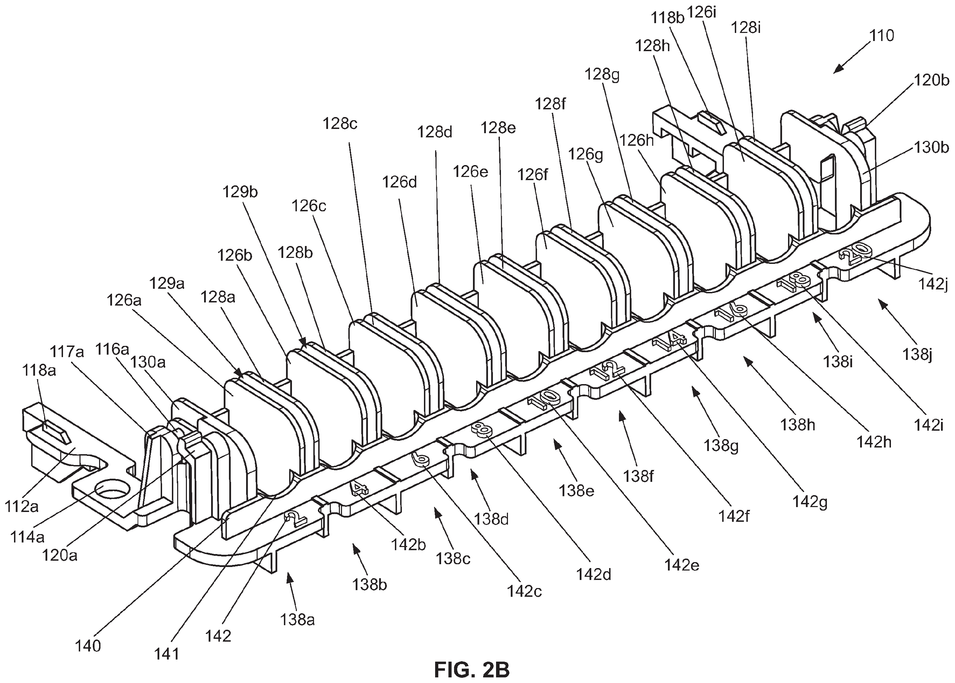

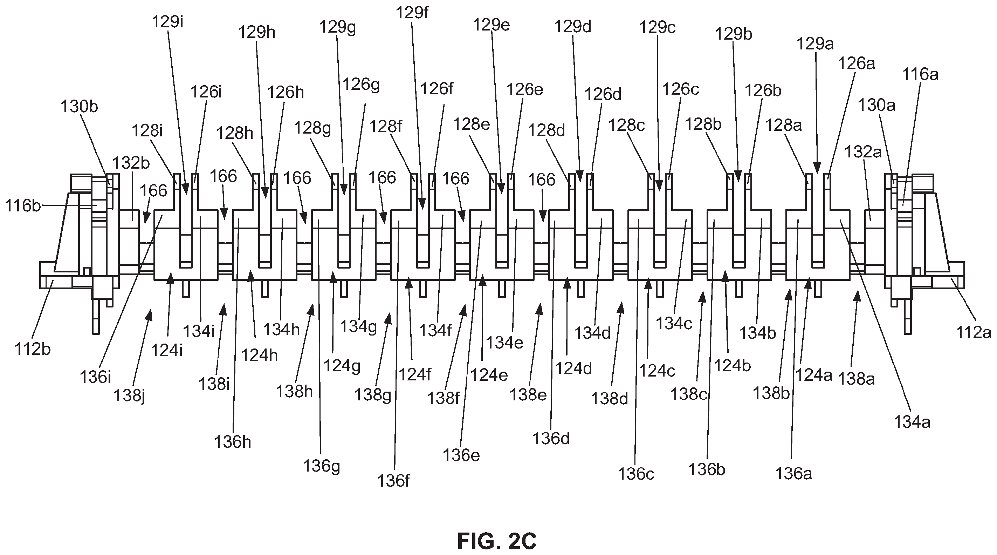

Figs. 2A, 2B, and 2C illustrate a front view, a perspective view, and a top view, respectively, of the base 110 for the safety barrier 100 shown in Figs. 1A-1C. The base 110 comprises a pair of opposing arms 112a, 112b joined by a bridge portion 122 that extends between the opposing arms 112a, 112b. The arms 112a, 112b and bridge portion 122 form an elongated U-shaped configuration. For example, the first arm 112a may be disposed on a first side (e.g., a left side) of the safety barrier 100 and the second arm 112b may be disposed on a second side (e.g., a right side) of the safety barrier 100. The base 110 may include a coupling aperture 114a disposed on the first arm 112a. The coupling aperture 114a may be used to receive a coupling stud (e.g., cover studs 14a, 14b, or the like) to position the safety barrier 100 on a switch for multi-circuit testing as described in more detail herein. The base 110 may include an attachment rod 116a extending between wall 130a and projection 117a protruding from the first arm 112a. The attachment rod 116a may be configured to engage a hinge (e.g., hinge 170, or the like) and define a pivot point for the cover 150 to allow the cover 150 to move (e.g. rotate) relative to the base 110. The base 110 may include a support 118a disposed on the first arm 112a. The support 118a may provide support for the cover 150 while the cover 150 is disposed in the first engaged position, as shown in Fig. 1C. The base 110 may include a base engagement member 120a disposed on the first arm 112a. The base engagement member 120a may be configured to engage a cover engagement member (e.g., cover engagement member 158a, cover engagement member 158b, or the like) on a first side of the base 110 to maintain the cover 150 in the second engaged position with the base 110.

The base 110 may include a second coupling aperture 114b, attachment rod 116b, projection 117b, a second support 118b, and engagement member 120b, that are substantially similar to the first coupling aperture 114a, attachment rod 116a, projection 117a, the first support 118a, and base engagement member 120a, respectively, disposed on the second arm 112b. The coupling aperture 114b may be used to receive a coupling stud (e.g., cover studs 14a, 14b, or the like) to position the safety barrier 100 on a switch for multi-circuit testing. The attachment rod 116b may be configured to engage a hinge (e.g., hinge 170, or the like) and define a pivot point for the cover 150 to allow the cover 150 to move (e.g. rotate) relative to the base 110. The projection 117a may protrude from the second arm 112b substantially similar to the projection 117a protruding from the first arm 112a. The support 118b may provide a base for a second side of the cover 150 to rest on, similar to the cover 150 resting on support 118a shown in Fig. 1C, while the cover 150 is disposed in the first engaged position with the base 110. The base engagement member 120b may be configured to engage a cover engagement member (e.g., cover engagement member 158a, cover engagement member 158b, or the like) on a second side of the base 110 to maintain the cover 150 in the second engaged position with the base 110.

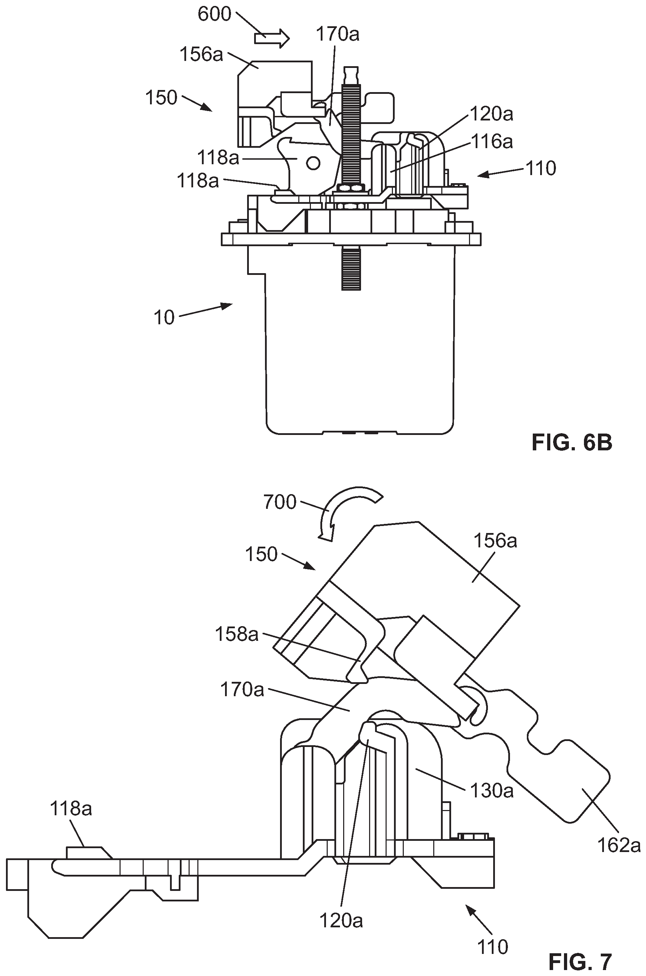

The base 110 comprises at least one flap pair 124a, 124b, 124c, 124d, 124e, 124f, 124g, 124h, 124i, (collectively 124a -124i) extending from the bridge portion 122. Each flap pair 124a-124i comprises a corresponding first flap 126a, 126b, 126c, 126d, 126e, 126f, 126g, 126h, 126i (collectively 126a-126i) paired with a corresponding second flap 128a, 128b, 128c, 128d, 128e, 128f, 128g, 128h, 128i (collectively 128a-128i). Each first flap 126a - 126i may be disposed on a first side (e.g., a left side) of a corresponding flap pair 124a -124i and each second flap 128a-128i may be disposed on a second side (e.g., a right side) of a corresponding flap pair 124a - 124i. As best shown in Fig. 2C, a portion of each of the at least one flap pair 124a-124i that is disposed proximate to a switch for multicircuit testing (e.g., switch 10, or the like, shown in Fig 6A and 6B) may be shaped to provide sufficient clearance for a current jack of a switch for multi-circuit testing when the safety barrier 100 is positioned on the switch for multi-circuit testing.

The base 110 may also comprise a plurality of barrier channels 129a, 129b, 129c, 129d, 129e, 129f, 129g, 129h, 129i (collectively 129a-129i). Each of the barrier channels 129a - 129i may be defined within each flap pair 124a -124i between corresponding first flaps 126a -126i and second flaps 128a-128i. For example, as shown in Fig. 1B, barrier channel 129a is defined between first flap 126a and second flap 128a, barrier channel 129b is defined between first flap 126b and second flap 128b, and the like. The base 110 may include any number of flap pairs 124a-124i first flaps 126a-126i, second flaps 128a-128i, and barrier channels 129a-129i as required for use with a switch for multi-circuit testing. For example, the base 110 may include nine flap pairs 124a-124i, nine first flaps 126a-126i, nine second flaps 128a-128i, and nine barrier channels 129a-129i, but is not limited thereto.

The base 110 may comprise first laterally extending portions 134a, 134b, 134c, 134d, 134e, 134f, 134g, 134h, 134i (collectively 134a-134i) each extending from one of the respective first flaps 126a-126i. Each of the first laterally extending portions 134a-134i may extend laterally in a first direction (e.g., to the left). Each of the first laterally extending portions 134a-134i may laterally extend into a switch channel 164a, 164b, 164c, 164d, 164e, 164f, 164g, 164h, 164i, 164j (collectively 164a-164j), described in more detail below, that is disposed adjacent to the first side of each flap pair 124a-124i. The base 110 may comprise second laterally extending portions 136a-136i each extending from one of the second flaps 128a-128i in a second direction (e.g., to the right). Each of the second laterally extending portions 136a-136i may laterally extend into a switch channel 164a-164j that is disposed adjacent to the second side of each flap pair 124a-124i.

The base 110 may include at least one clip slot 138a, 138b, 138c, 138d, 138e, 138f, 138g, 138h, 138i, 138j (collectively 138a-138j) extending through a portion of the bridge portion 122. Each of the clip slots 138a-138j may correspond to one of the switch channels 164a-164j defined by the safety barrier 100. Each clip slot 138a-138j may be adapted to align and receive an alligator clip (not shown) for attachment to a crimped section of a test switch blade that is positioned within the corresponding switch channels 164a-164j.

The base 110 may also comprise a first wall 130a and a second wall 130b to correspond to an inner edge of the first opposing arm 112a and the second opposing arm 112b, respectively. Wall 130a may oppose first flap 126a along an outer periphery of switch channel 164a. Wall 130b may oppose second flap 128i along an outer periphery of switch channel 164j. The first wall 130a may include a laterally extending member 132a extending in the second direction, similar to laterally extending portions 136a-136i. The second wall 130b may include a laterally extending member 132b laterally extending in the first direction, similar to laterally extending portions 134a-134i.

The base 110 may include a probe seat 140 disposed on the bridge portion 122. The support 140 may define at least one curved portion 141, where each curved portion 141 corresponds to one of the switch channels 164a-164j. Each curved portion 141 may be configured to receive a test probe (not shown) to allow the test probe to rest on the probe seat 140 for proper insertion of the test probe to make contact with an intended test switch blade and prevent accidental touching of unintended test switch blades.

The base 110 may include at least one base visual switch indicator 142. Each visual switch indicator 142 may be disposed on the bridge portion 122 to correspond to one of the switch channels 164a-164j defined by the safety barrier 100. The base visual switch indicator 142 may be a letter, number, symbol, and the like to indicate a terminal number assigned to corresponding pole positions for the test switch blade housed by the switch channels 164a-164j. Additionally, the base visual switch indicator 142 may be printed, hot stamped, adhered, and the like to the bridge portion 122.

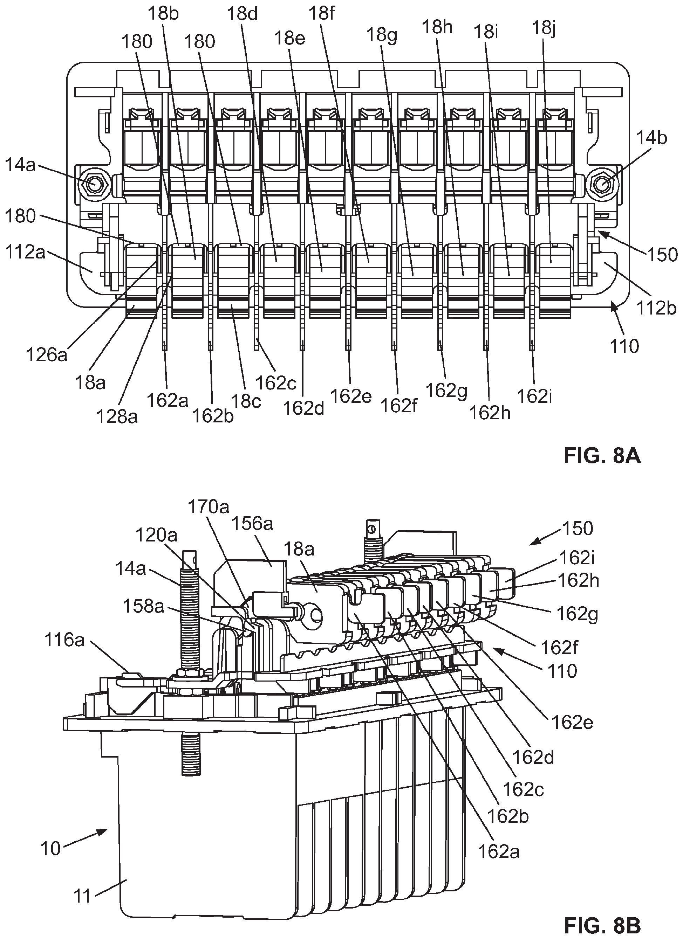

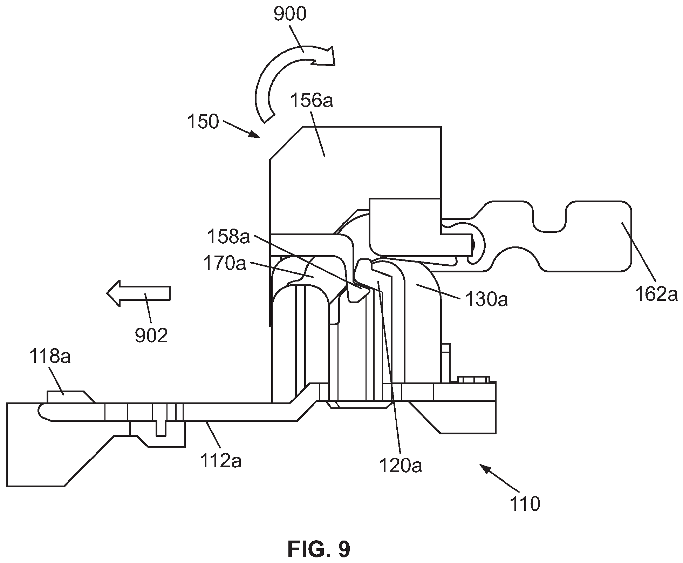

Figs. 3A and 3B illustrate a front view and a perspective view, respectively, of a cover 150 for the safety barrier 100 of Figs. 1A-1C. The cover 150 includes a pair of opposing peripheral portions 152a, 152b joined by a body 160 that extends between the opposing peripheral portions 152a, 152b. The peripheral portions 152a, 152b and body 160 form an elongated U-shaped configuration. For example, the first peripheral portion 152a may be disposed on a first side (e.g., a left side) of the cover 150 and the second peripheral portion 152b may be disposed on a second side (e.g., a right side) of the cover 150. The cover 150 may include a first attachment rod 154a disposed on the first peripheral portion 152a. The attachment rod 154a may be configured to engage a hinge (e.g., hinge 170, or the like) to allow the cover 150 to connect to the base 110. The cover 150 is configured to move(e.g. rotate) between a first engaged position (e.g., a down position), as shown in Figs. 1A-1C, and a second engaged position (e.g., an up position), as shown in Figs. 8A, 8B, and 9, with the base 110. The cover 150 may include a first handle 156a disposed on the first peripheral portion 152a. The first handle 156a may be used to support movement of the cover 150 between the first engaged position and the second engaged position. For example, the handle 156a may be grasped by a user to allow the user to efficiently move the cover 150 between the first engaged position and the second engaged position, as described herein. The cover 150 may include a first cover engagement member 158a disposed on the first arm 112a. The first cover engagement member 158a may be configured to engage a base engagement member (e.g., base engagement member 120a, base engagement member 120b, or the like), as shown in Fig. 9, to create a snap-fit between the cover 150 and the base 110 to maintain the cover 150 in the second engaged position with the base 110. The first cover engagement member 158a may also engage an arm (e.g., first arm 112a, second arm 112b, or the like), as shown in Fig. 1C, to create a snap-fit between the cover 150 and the base 110 to maintain the cover 150 in the first engaged position with the base 110.

The cover 150 may include a second attachment rod 154b, a second handle 156b, and a second cover engagement member 158b, that are substantially similar to the first attachment rod 154a, the first handle 156a, and the first cover engagement member 158a, respectively, disposed on the second peripheral portion 152b. The second attachment rod 154b may receive a second hinge (e.g., hinge 170, or the like) to hingably connect a second side of the cover 150 to a corresponding side of the base 110. The second cover engagement member 158b may be configured to engage a base engagement member (e.g., base engagement member 120a, base engagement member 120b, or the like), similar to the engagement of first cover engagement member 158a and base engagement member 120a shown in Fig. 9, to create a snap-fit between the cover 150 and the base 110 to maintain the cover 150 in the second engaged position. The second cover engagement member 158b may also engage an arm (e.g., first arm 112a, second arm 112b, or the like), similar to the engagement of first cover engagement member 158a and first arm 112a shown in Fig. 1C, to create a snap-fit between the cover 150 and the base 110 to maintain the cover 150 in the first engaged position.

The cover 150 includes at least one barrier rib 162a, 162b, 162c, 162d, 162e, 162f, 162g, 162h, 162i (collectively 162a-162i) extending from the body 160. Each barrier rib 162a-162i may correspond to one of the flap pairs 124a-124i that extend from the bridge portion 122 when the cover 150 is disposed in the first engaged position. Each barrier rib 162a-162i and the corresponding flap pair 124a-124i may collectively define at least one switch channel 164a-164j, shown in Fig. 1A, extending between the base 110 and the cover 150 while the cover 150 is disposed in the first engaged position. Each of the at least one switch channel 164a-164j is configured to house a test switch blade from a switch for multi-circuit testing. Each of the at least one switch channel 164a-164j may also allow a user to maintain visibility of a make before break action for each test switch blade for a switch for multi-circuit testing that is disposed proximate the bridge portion 122 within each of the at least one switch channel 164a-164j.

Each of the at least one barrier rib 162a-162i, may comprise a length such that a portion of each barrier rib 162a-162i, extends into each corresponding barrier channel 129a-129i while the cover 150 is disposed in the first engaged position. The first flaps 126a-126i and the second flaps 128a-128i may support the portion of the barrier rib 162a-162i, that extends into the corresponding barrier channel 129a-129i to prevent lateral movement of the at least one barrier rib 162a-162i while the cover 150 is disposed in the first engaged position.

Each of the at least one switch channel 164a-164j may comprise a test probe guide channel 166. The test probe guide channel 166 for each of switch channels 164b-164i may be defined by a corresponding first laterally extending portion 134b-134i and a corresponding second laterally extending portion 136a-136h within each of switch channels 164b-164i. For example, the test probe guide channel 166 for switch channel 164b may be defined between second laterally extending portion 136a and first laterally extending portion 134b to direct the test probe into contact with the test switch blade within switch channel 164b. The test probe guide channel 166 for switch channel 164a may be defined between laterally extending member 132a and first laterally extending portion 134a. The test probe guide channel 166 for switch channel 164j may be defined between laterally extending member 132b and second laterally extending portion 136i. Each test probe guiding channel 166 may be used with the probe seat 140 to direct the test probe into a desired alignment for proper use of the test probe and testing of a intended test switch blade. Each test probe guiding channel 166 may also be sized to protect against insertion of objects, such as fingers, hands, large tools, and the like to prevent accidental touching of live components within switches for multi-circuit testing.

Fig. 4 illustrates a front view of a hinge 170 for connecting the base 110 and the cover 150 of the safety barrier 100 of Figs. 1A-1C. The hinge 170 may include a first end 172 and an opposing second end 174. Each end 172, 174 may have a hook 176a, 176b, respectively. The hooks 176a, 176b may be configured to engage an attachment rod (e.g., attachment rod 116a, 116b, attachment rod 154a, 154b, or the like) to create snap fit between the hinge 170 and the base 110 and/or between the hinge 170 and the cover 150. The hinge 170 may be disposed in a substantially concave orientation when attached to each of the base 110 and cover 150, as shown in Fig. 1C.

Figs. 5A and 5B illustrate a front view and a perspective view, respectively, of a switch 10 for multi-circuit testing with the safety barrier 100 of Figs. 1A-1C in a first engaged position. The switch for multi-circuit testing 10 can be used for multi-circuit testing of switchboard relays, meters, and instruments. The switch for multi-circuit testing 10 comprises a switch body 12. The switch body 12 is configured to house at least one test switch blade 16a, 16b, 16c, 16d, 16e, 16f, 16g, 16h, 16i, 16j (collectively 16a-16j). Each test switch blade 16a-16j may be used to control a flow of electricity within a circuit. Each test switch blade 16a-16j may be actuated between a closed position, as shown in Figs. 5A and 5B, and an open position, as shown in Figs. 8A and 8B. Each test switch blade 16a-16j includes a corresponding handle 18a, 18b, 18c, 18d, 18e, 18f, 18g, 18h, 18i, 18j (collectively 18a-18j) to allow an operator to actuate each test switch blade 16a-16j between the open and closed positions while the cover 150 of the safety barrier 100 is disposed in the first engaged position. The switch 10 may comprise a plurality of cover studs 14a, 14b each disposed on opposing sides of the switch body 12. For example, the switch 10 may comprise a first cover stud 14a disposed on a first side (e.g., a left side) of the switch body 12 and a second cover stud 14b disposed on a second side (e.g., a right side) of the switch body 12, where the first and second sides are on opposing sides of the switch body 12.

The switch for multi-circuit testing 10 includes the safety barrier 100 disposed on the switch body 12. As shown in Figs. 5A and 5B, the cover studs 14a, 14b may extend through corresponding coupling apertures 114a, 114b. For example, coupling aperture 114a may receive a first cover stud 14a such that the first cover stud 14a extends therethrough and coupling aperture 114b may receive a second cover stud 14b such that the second cover stud 14b extends therethrough. The coupling apertures 114a, 114b may enable the safety barrier 100 to be positioned on existing switches quickly and easily without the need for extensive disassembly of these switches. Once the cover studs 14a, 14b are inserted through the coupling apertures 114a, 114b and the safety barrier 100 is positioned on the switch 10, the safety barrier 100 may be secured in position on the switch body 11 by a washer and nut tightened onto each cover stud 14a, 14b.

Figs. 6A and 6B illustrate a perspective view and a side view, respectively, of the switch 10 for multi-circuit testing of Figs. 5A and 5B with the safety barrier 100 of Figs. 1A-1C during movement of the cover 150 of the safety barrier 100 from the first engaged position to a second engaged position and each test switch blade 16a-16j includes a corresponding handle 18a-18j in a closed position. Fig. 7 illustrates a side view of the safety barrier of Figs. 1A-1C during movement of the cover 150 of the safety barrier 100 from the first engaged position to the second engaged position. Each of cover engagement members 158a, 158b may be disengaged from arms 112a, 112b, respectively, to initiate movement of the cover 150 of the safety barrier 100 from the first engaged position to the second engaged position. Once each of the cover engagement members 158a, 158b are disengaged from arms 112a, 112b, the hinges 170a, 170b may allow the cover 150 to swing forward, in a direction as indicated by arrow 600 (shown in Fig. 6B) from the first engaged position. During the movement of the cover 150 from the first engaged position to the second engaged position, the cover 150 may be swung forward until each of the first hinge 170a contacts the base 110, as shown in Fig. 7, at a first end of the base 110 and the second hinge 170b similarly contacts the base 110 at a second end of the base 110. While each of the hinges 170a, 170b maintain contact with the base 110, the cover 150 may be rotated about an axis extending between an attachment point between attachment rod 154a and the first hinge 170a and an attachment point between attachment rod 154b and the second hinge 170b, as indicated by arrow 700 (shown in Fig. 7), until the cover engagement members 158a, 158b engage the base engagement members 120a, 120b, respectively, to dispose the cover 150 into the second engaged position, as described below referring to Figs. 8A, 8B, and 9, with the base 110.

Figs. 8A and 8B illustrate a front view and a perspective view, respectively, of the switch 10 for multi-circuit testing of Figs. 5A and 5B with the cover 150 of the safety barrier 100 of Figs. 1A-1C disposed in the second engaged position and test switch blades 16a-16j disposed in an open position. Fig. 9 illustrates a side view of the safety barrier 100 of Figs. 1A-1C with the cover 150 of the safety barrier 100 disposed in the second engaged position. While the cover 150 of the safety barrier 100 is disposed in the second engaged position, the cover 150 may be configured to overlay any exposed test switch blades 16a-16j that are disposed in the open position to prevent any accidental touching of these exposed test switch blades 16a-16j. As best shown in Fig. 8A, while the cover 150 is disposed in the second engaged position, each of barrier ribs 162a-162i may be positioned within a corresponding barrier channel 129a-129i to be supported by first flaps 126a-126i and second flaps 128a-128i and prevent lateral movement and deformation of barrier ribs 162a-162i. While in the second engaged position, the cover 150 may also allow a test probe (not shown) to be inserted into a passage 180 defined between the cover 150 and each of the handle 18a-18j that are disposed in the open position. The passage 180 may be sized such that the test probe may be able to extend through passage 180 and make contact with a test switch blade 16a-16j while the cover 150 is disposed in the second engaged position with the base 110.

Each of the cover engagement members 158a, 158b may be disengaged from the base engagement members 120a, 120b, respectively, to initiate movement of the cover 150 of the safety barrier 100 from the second engaged position to the first engaged position. Once each of the cover engagement members 158a, 158b are disengaged from the base engagement members 120a, 120b, the cover 150 may be rotated about an axis extending between an attachment point between attachment rod 154a and the first hinge 170a and an attachment point between attachment rod 154b and the second hinge 170b, as indicated by arrow 900 (shown in Fig. 9). Once rotated, the hinges 170a, 170b may allow the cover 150 to swing backward, in a direction as indicated by arrow 902 (shown in Fig. 9) from the second engaged position. The cover 150 may be swung backward until the cover 150 is substantially planar with the base 110 of the safety barrier and the cover engagement members 158a, 158b may be engaged with arms 112a, 112b to return the cover 150 to the first engaged position.

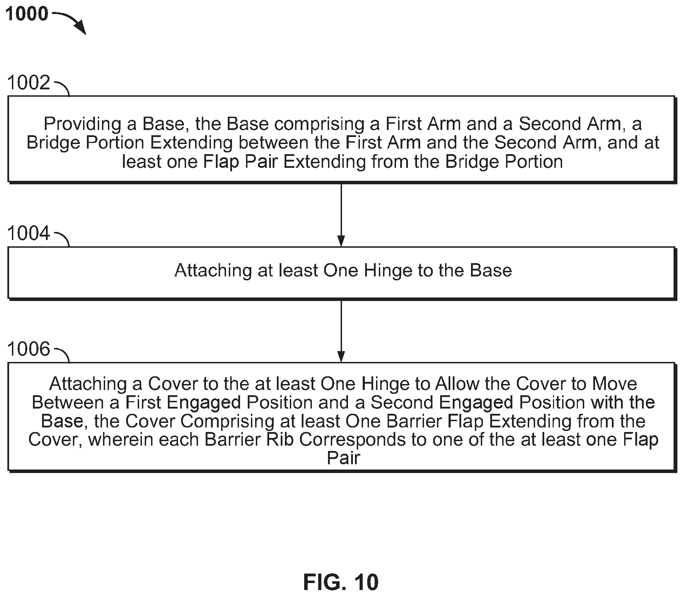

Fig. 10 illustrates a flowchart of an exemplary method 1000 of assembly for a safety barrier 100 for a switch 10 for multi-circuit testing.

At 1002, the method 1000 comprises providing a base 110. The base 110 comprises a first arm 112a and a second arm 112b. Each arm 112a, 112b may be configured to receive a cover stud 14a, 14b associated with the switch 10 for multi-circuit testing. The base 110 also comprises a bridge portion 122 extending between and connecting the first arm 112a and the second arm 112b and at least one flap pair 124a-124i extending from the bridge portion 122.

At 1004, the method 1000 comprises attaching at least one hinge 170 to the base 110. Attaching the at least one hinge 170 to the base may comprise attaching a first hinge 170a to a first side of the base 110 at a first end of the first hinge 170a and attaching a second hinge 170b to a second side of the base 110 at a first end of the second hinge 170b.

At 1006, the method 1000 comprises attaching a cover 150 to the at least one hinge 170 to allow the cover 150 to move between a first engaged position and a second engaged position with the base 110. Attaching a cover 150 to the at least one hinge 170 may comprise attaching the first hinge 170a to a first side of the cover 150 at a second end of the first hinge 170a and attaching the second hinge 170b to a second side of the cover 150 at a second end of the second hinge 170b.

As used herein, an element or step recited in the singular and proceeded with the word "a" or "an" should be understood as not excluding plural elements or steps unless such exclusion is explicitly recited. Furthermore, references to "one embodiment" of the disclosure or an "exemplary" or "example" embodiment are not intended to be interpreted as excluding the existence of additional embodiments that also incorporate the recited features. Likewise, limitations associated with "one embodiment" or "an embodiment" should not be interpreted as limiting to all embodiments unless explicitly recited.

Disjunctive language such as the phrase "at least one of X, Y, or Z," unless specifically stated otherwise, is generally intended, within the context presented, to disclose that an item, term, etc. may be either X, Y, or Z, or any combination thereof (e.g., X, Y, and/or Z). Likewise, conjunctive language such as the phrase "at least one of X, Y, and Z," unless specifically stated otherwise, is generally intended, within the context presented, to disclose at least one of X, at least one of Y, and at least one of Z.

The disclosed systems and methods are not limited to the specific embodiments described herein. Rather, components of the systems or steps of the methods may be utilized independently and separately from other described components or steps.

This written description uses examples to disclose various embodiments, which include the best mode, to enable any person skilled in the art to practice those embodiments, including making and using any devices or systems and performing any incorporated methods. The patentable scope is defined by the claims and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A switch safety barrier, the switch safety barrier comprising:
a base configured to be positioned on a switch for multi-circuit testing, the base comprising:
a first arm and a second arm;
a bridge portion extending between the first arm and the second arm; and
at least one flap pair extending from the bridge portion; and
a cover connected to the base by a first hinge at a first end of the cover and a second hinge at a second end of the cover and movable between a first engaged position and a second engaged position, the cover comprising:
at least one barrier rib extending from the cover, each barrier rib corresponding to one of the at least one flap pair.

2. The switch safety barrier of claim 1, wherein each of the at least one flap pair comprises a first flap disposed on a first side of the flap pair and a second flap disposed on a second side of the flap pair.

3. The switch safety barrier of claim 2, wherein each of the at least one flap pair defines a barrier channel between the first flap and the second flap, wherein each barrier channel corresponds to one barrier rib of the at least one barrier rib.

4. The switch safety barrier of claim 3, wherein each of the at least one barrier rib comprises a length such that a portion of each barrier rib extends into each corresponding barrier channel to prevent movement of the at least one barrier rib when the cover is in the first engaged position.

5. The switch safety barrier of any of the preceding claims, wherein the switch safety barrier comprises at least one switch channel defined by the at least one flap pair and the at least one barrier rib.

6. The switch safety barrier of claim 5, wherein the base comprises a first laterally extending portion extending from each first flap in a first direction and a second laterally extending portion extending from each second flap in a second direction.

7. The switch safety barrier of claim 6, wherein each of the at least one switch channel comprising a test probe guiding channel defined by a corresponding first laterally extending portion and a corresponding second laterally extending portion.

8. The switch safety barrier of any of the preceding claims, wherein the bridge portion comprises a probe seat configured to support a test probe while the test probe is disposed within the at least one switch channel.

9. The switch safety barrier of any of the preceding claims, wherein the cover further comprises at least one cover engagement member configured to engage the base in each of the first engaged position and the second engaged position.

10. A switch for multi-circuit testing, the switch comprising:
at least one test switch blade;
a switch body configured to house the at least one test switch blade; and
a safety barrier positioned on the switch body, the safety barrier according to any of the preceding claims.

11. A method of assembly for a safety barrier for a switch for multi-circuit testing, the method comprising:
providing a base, the base comprising:
a first arm and a second arm;
a bridge portion extending between the first arm and the second arm; and
at least one flap pair extending from the bridge portion;
attaching at least one hinge to the base; and
attaching a cover to the at least one hinge to allow the cover to move between a first engaged position and a second engaged position with the base, the cover comprising:
at least one barrier rib extending from the cover, each barrier rib corresponding to one of the at least one flap pair.

12. The method of claim 11, wherein attaching the at least one hinge to the base comprises:
attaching a first hinge to a first side of the base at a first end of the first hinge; and
attaching a second hinge to a second side of the base at a first end of the second hinge.

13. The method of claim 12, wherein attaching a cover to the at least one hinge comprises:
attaching the first hinge to a first side of the cover at a second end of the first hinge; and
attaching the second hinge to a second side of the cover at a second end of the second hinge.
